# EUROPÄISCHE PATENTSCHRIFT

(11) **EP 0 537 203 B1**
(45) Veröffentlichungstag und Bekanntmachung des Hinweises auf die Patenterteilung: **14.09.1994**
(21) Anmeldenummer: 91911441.3
(22) Anmeldetag: 18.06.1991
(51) Int. Cl.: G11C 5/00, G11C 11/404

(54) **ANORDNUNG MIT SELBSTVERSTÄRKENDEN DYNAMISCHEN MOS-TRANSISTORSPEICHERZELLEN**
DEVICE WITH SELF-AMPLIFYING DYNAMIC MOS TRANSISTOR STORAGE CELLS
DISPOSITIF AVEC CELLULES DE MEMOIRE DYNAMIQUES A AUTO-AMPLIFICATION POUR TRANSISTORS M.O.S.

(30) Priorität: 03.07.1990 DE 4021127
(43) Veröffentlichungstag der Anmeldung: 21.04.1993
(73) Patentinhaber: SIEMENS AKTIENGESELLSCHAFT, 80333 München (DE)
(72) Erfinder: KRAUTSCHNEIDER, Wolfgang, Dr., D-8012 Ottobrunn (DE); RISCH, Lothar, Dr., D-8014 Neubiberg (DE); LAU, Klaus, D-8152 Vagen (DE)
(86) Internationale Anmeldenummer: DE9100502
(87) Internationale Veröffentlichungsnummer: WO9201287

(56) Entgegenhaltungen:
- US-A- 4 805 148
- IEEE CIRCUITS AND DEVICE MAGAZINE, vol. 5, no. 1, January 1989, New York, US, pages 27-36; LU: "Advanced Cell Structures for Dynamic Rams"
- JEE JOURNAL OF ELECTRONIC ENGINEERING, vol. 23, no. 230, January 1986, TOKYO JP, page 18; "NEC DEVELOPS MEMORY CELL ARCHITECTURE FOR 4-MEGABIT DRAM"

## Beschreibung

Anordnung mit selbstverstärkenden dynamischen MOS-Transistorspeicherzellen.

Die Erfindung betrifft eine Anordnung mit selbstverstärkenden dynamischen MOS-Transistorspeicherzellen nach dem Oberbegriff des Patentanspruchs 1.

Eine Anordnung selbstverstärkender dynamischer MOS-Transistorspeicherzellen dieser Art ist aus der Veröffentlichung mit dem Titel "New Dynamic RAM Cell for VLSI Memories" von T. Tsuchiya und M. Itsumi aus IEEE Electron. Device Letters, Vol. EDL-3, No. 1, January 1982 (Seite 7 bis 10) bekannt. Dabei handelt es sich um eine Speicherzelle mit zwei Schreibleitungen und einer Leseleitung die aus einem MOS-FET, einem MOS-Kondensator und einem Junction-FET aufgebaut ist.

Der Erfindung liegt die Aufgabe zugrunde, eine Anordnung mit selbstverstärkenden dynamischen MOS-Transistorspeicherzellen der eingangs genannten Art anzugeben, die einfach aufgebaut ist, kurze Zugriffszeiten ermöglicht, eine geringe Empfindlichkeit gegen Treffer von Alphateilchen besitzt und vor allem deren Zellgeometrie skalierbar ist, ohne daß dabei die auf die Bitleitung auslesbare Ladungsmenge wesentlich verkleinert wird. Die Aufgabe wird erfindungsgemäß durch die im kennzeichnenden Teil des Patentanspruchs 1 angegebenen Merkmale gelöst.

Der mit der Erfindung erzielbare Vorteil liegt insbesondere darin, daß bei der nach der Erfindung ausgebildeten Anordnung mit selbstverstärkenden dynamischen MOS-Transistorspeicherzellen, aufgrund höherer Kapazitätswerte bei gleichem Flächenbedarf und geringerer Leckstromverluste, ein besseres Ladungsspeicherungsverhalten möglich ist als bei der eingangs zitierten Speicherzelle. Weitere Vorteile sind die einfacher Herstellbarkeit des MOS-Transistors im Vergleich zum Junction-FET und eine geringere Soft-Error-Rate durch die geringere Empfindlichkeit gegenüber Alpha-Strahlen aufgrund einer im Vergleich zur Zellfläche kleineren empfindlichen Fläche.

Die Patentansprüche 2 bis 8 sind auf bevorzugte Ausbildungen der erfindungsgemäßen Anordnung mit selbstverstärkenden dynamischen MOS-Transistorspeicherzellen gerichtet.

Die Erfindung wird nachfolgend anhand der Zeichnung näher erläutert. Dabei zeigt:
- Figur 1: eine Schnittdarstellung zweier benachbarter MOS-Transistorspeicherzellen einer erfindungsgemäßen Speicherzellenanordnung mit planar aufgebauten Transistoren und jeweils einem n⁺n-Übergang als spannungsabhängiger Widerstand,
- Figur 2: eine Schnittdarstellung einer MOS-Transistorspeicherzelle einer erfindungsgemäßen Speicherzellenanordnung mit planar ausgeführten Transistoren und einem Schottky-Übergang als spannungsabhängiger Widerstand,
- Figur 3: eine Schnittdarstellung einer MOS-Transistorspeicherzelle einer erfindungsgemäßen Speicherzellenanordnung mit planar ausgeführten Transistoren und einem n⁺p⁺-Übergang als spannungsabhängiger Widerstand,
- Figur 4: eine Schnittdarstellung einer MOS-Transistorspeicherzelle einer erfindungsgemäßen Speicherzellenanordnung mit planarem Auswahltransistor und einem Speichertransistor in Trenchausführung,
- Figur 5: eine Schnittdarstellung einer MOS-Transistorspeicherzelle einer erfindungsgemäßen Speicherzellenanordnung mit einem Auswahltransistor und einem Speichertransistor in Trenchausführung,
- Figur 6: ein Ersatzschaltbild einer MOS-Transistorspeicherzelle einer erfindungsgemäßen Speicherzellenanordnung,
- Figur 7: ein Diagramm zur Verdeutlichung der zeitlichen Spannungsverläufe beim Einschreiben von Informationen in eine erfindungsgemäße Speicherzellenanordnung,
- Figur 8: ein Diagramm zur Verdeutlichung der zeitlichen Strom- und Spannungsverläufe zum Auslesen von Informationen aus einer MOS-Transistorspeicherzelle einer erfindungsgemäßen Speicherzellenanordnung.

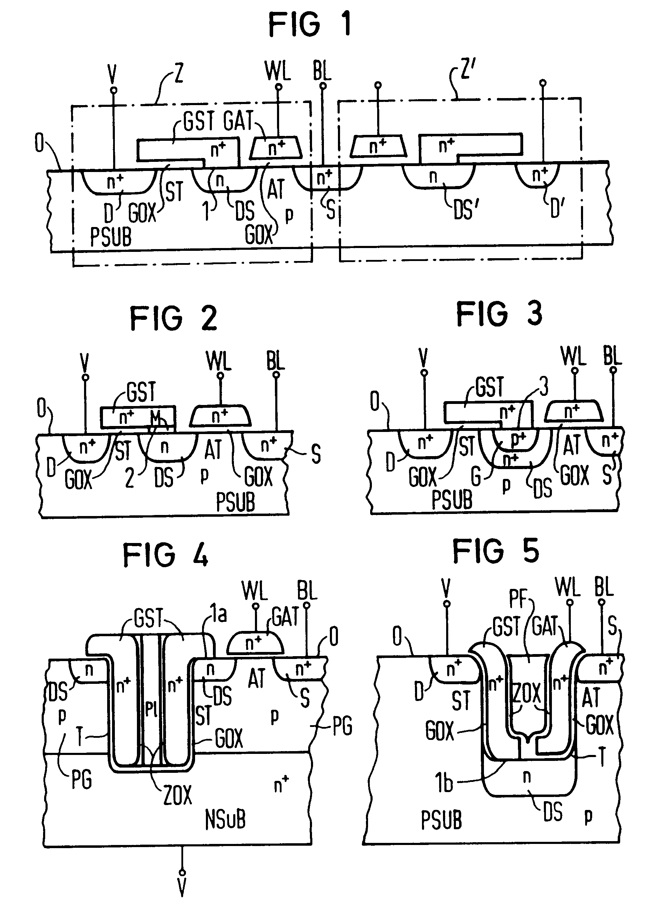

Die Schnittdarstellung von Figur 1 zeigt eine bevorzugte Ausbildung zweier benachbarter erfindungsgemäßer MOS-Transistorspeicherzellen Z und Z′. Die Zellen Z und Z′ besitzen ein p-dotiertes Substrat PSUB, das beispielsweise aus Silizium besteht und sich auf Bezugspotential befindet. In dieses Substrat PSUB sind n⁺-dotierte Draingebiete D und D′, n-dotierte Drain-SourceGebiete DS und DS′ und ein n⁺-dotiertes und beiden Speicherzellen Z und Z′ gemeinsames Source-Gebiet S von einer Oberfläche O des Substrats PSUB her eingebracht. Das gemeinsame Source-Gebiet S ist mit einer beiden Speicherzellen Z und Z′ gemeinsamen Bitleitung BL verbunden. Da die Speicherzellen Z und Z′ völlig symmetrisch sind, gelten die im folgenden für Z gemachten Aussagen entsprechender Weise auch für Z′. Das beiden Speicherzellen Z und Z′ gemeinsame Source-Gebiet S, das Drain-Source-Gebiet DS und das zwischen den beiden Gebieten S und DS liegende Substrat PSUB bilden zusammen mit einer durch ein dünnes Gateoxid GOX vom Substrat PSUB getrennten und n⁺-dotierten Gate-Elektrode GAT einen Auswahltransistor AT. Das Drain-Source-Gebiet DS stellt das Drain-Gebiet des Auswahltransistors AT dar und bildet gleichzeitig das Source-Gebiet des Speichertransistors ST. Der Speichertransistor ST wird aus dem Drain-Source-Gebiet DS, einem Drain-Gebiet D und einem dazwischenliegenden Substrat PSUB zusammen mit einer durch das dünne Gateoxid GOX vom Substrat PSUB getrennten und n⁺-dotierten Gate-Elektrode GST des Steuertransistors ST gebildet. Das Drain-Gebiet D ist mit einer Versorgungsspannungsleitung V und die Gate-Elektrode GAT des Auswahltransistors AT ist mit einer Wortleitung WL elektrisch leitend verbunden. Die Gate-Elektrode GST des Steuertransistors ST und das Drain-Source-Gebiet DS berühren sich und bilden einen n⁺n-Übergang 1.

Figur 2 zeigt eine bevorzugte Ausbildung einer Speicherzelle Z einer erfindungsgemäßen Anordnung von Speicherzellen mit planar ausgeführten Transistoren, wobei sich hierbei die Speicherzelle gegenüber der in Figur 1 gezeigten Speicherzelle darin unterscheidet, daß die Gate-Elektrode GST des Speichertransistors ST mit Hilfe eines Schottky-Übergangs 2 an das Drain-Source-Gebiet DS angeschlossen ist. Der Schottky-Übergang 2 wird hierbei durch die n⁺-dotierte Gate-Elektrode GST und einen Metallfilm M gebildet.

In Figur 3 ist, wie bei Figur 1 und 2, eine bevorzugte Ausbildung einer MOS-Transistorspeicherzelle einer erfindungsgemäßen Anordnung von Speicherzellen mit planar ausgeführten Transistoren dargestellt, bei der jedoch eine polykristalline oder polykristallin-silizidierte n⁺-Gate-Elektrode GST auf ein p⁺-Gebiet G trifft um einen spannungsabhängigen Widerstand durch einen n⁺p⁺-Übergang 3 zu bilden. Ein ausreichend hochdotierter p⁺n⁺-Übergang stellt dabei einen ohmschen Kontakt zum Source-Drain-Gebiet DS her.

Eine andere bevorzugte Ausbildung der MOS-Speicherzelle einer erfindungsgemäßen Anordnung mit Speicherzellen weist, wie in Figur 4 gezeigt, einen planar ausgebildeten Auswahltransistor AT und einen Speichertransistor ST in Trench-Ausführung auf. In einem n-dotierten Substrat NSUB befindet sich hierbei ein p-dotiertes und auf Bezugspotential liegendes Gebiet PG, in das ein n-dotiertes Drain-Source-Gebiet DS und ein n⁺-dotiertes Source-Gebiet S von der Oberfläche O her eingebracht sind. Wie beispielsweise in Figur 1, wird ein planarer Auswahltransistor AT durch ein n-dotiertes Drain-Source-Gebiet DS, ein gemeinsames n⁺-dotiertes Source-Gebiet S und dem dazwischenliegenden p-dotierten Gebiet PG zusammen mit einer durch ein dünnes Gateoxid GOX vom Substrat NSUB getrennten und n⁺-dotierten Gate-Elektrode GAT des Auswahltransistors AT gebildet. Das Source-Gebiet S ist mit einer Bitleitung BL und die Gate-Elektrode GAT des Auswahltransistors AT ist mit einer Wortleitung WL verbunden. In das Substrat NSUB ist ein Graben T (Trench) eingeätzt, der etwas tiefer ist als das p-dotierte Gebiet PG. Das n-dotierte Substrat NSUB ist in diesem Fall mit der Versorgungsspannungsleitung V verbunden, so daß auf der Chipoberfläche, zur Kontaktierung der Zellen, nur die matrixförmig angeordneten Bit- und Wortleitungen BL und WL erforderlich sind. Ein n⁺-dotiertes Gate-Elektrode GST des Steuertransistors ST ist zum größten Teil in den Graben T (Trench) verlegt, wobei das Gate-Gebiet GST durch ein dünnes Gateoxid GOX vom Substrat NSUB getrennt ist und den Graben T auskleidet. Im Innern des ausgekleideten Grabens befindet sich, zur Vergrößerung einer am Gate des Speichertransistors ST wirksamen Kapazität C, ein elektrisch leitender Bereich Pl (Platte), beispielsweise aus polykristallinem Silizium, der durch ein Zwischenoxid ZOX vom Gate-Gebiet GST isoliert ist und sich zum Beispiel auf einem Potential von V_{DD}/2 befindet. Die Gate-Elektrode GST des Steuertransistors ST und das Drain-Source-Gebiet DS berühren sich und bilden so einen n⁺n-Übergang 1a.

Bei der in Figur 5 gezeigten bevorzugten Ausbildung einer MOS-Transistorspeicherzelle einer erfindungsgemäßen Anordnung von Speicherzellen sind sowohl ein Auswahltransistor AT als auch ein Steuertransistor ST in Trenchausführung realisiert. Hierzu sind ein n⁺-dotiertes gemeinsames Source-Gebiet S und ein n⁺-dotiertes Drain-Gebiet D von der Oberfläche O her in ein p-dotiertes Substrat PSUB eingebracht und reichen jeweils bis an den Rand eines Grabens T (Trench). Ein n-dotiertes Drain-Source-Gebiet DS befindet sich direkt unterhalb des Grabens T, welcher durch ein dünnes Gateoxid GOX bis auf einen n⁺n-Übergang 1b zwischen der Gate-Elektrode GST des Speichertransistors ST und dem Drain-Source-Gebiet DS ausgekleidet ist. Im durch das dünne Gateoxid ausgekleideten Graben T befindet sich, von der Gate-Elektrode GST isoliert, ebenfalls die Gate-Elektrode GAT des Auswahltransistors AT. Die Gate-Elektrode GAT des Auswahltransistors AT ist mit einer Wortleitung WL verbunden und, wie die Gate-Elektrode GST des Speichertransistors ST, durch ein Zwischenoxid ZOX an der Innenseite des Grabens von einer Grabenfüllung PF aus polykristallinem Silizium isoliert. Das n⁺-dotierte Drain-Gebiet D ist mit der Versorgungsspannungsleitung V und das n⁺-dotierte gemeinsame Source-Gebiet S mit einer Bitleitung BL verbunden.

Alle Kombinationen zwischen den Übergängen 1 bis 3 und den Transistorausführungsformen Planar/Planar, Planar/Trench, Trench/Planar und Trench/Trench sind herstellbar. Stellvertretend hierfür sind in den Figuren 1 bis 3 die Übergänge 1 bis 3 nur zusammen mit einer Planar/Planar-Transistorausführung gezeigt und in den Figuren 4 und 5 wird nur der Übergang 1 (1a, 1b) zusammen mit einer Planar/Trench-Transistorausführung sowie einer Trench/Trench-Transistorausführung gezeigt.

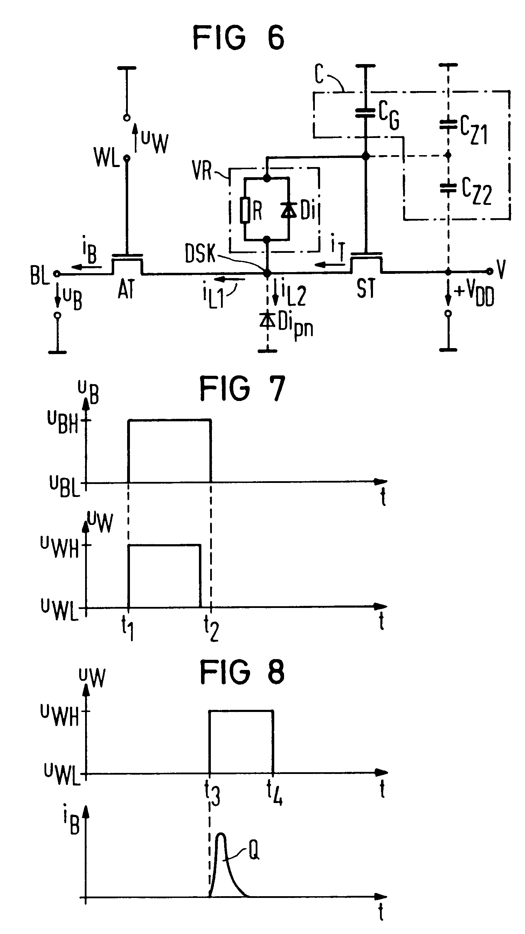

Das Ersatzschaltbild einer MOS-Transistorspeicherzelle einer erfindungsgemäßen Anordnung mit Speicherzellen ist in Figur 6 dargestellt, wobei die nur zweitrangig oder parasitär wirksamen Komponenten durch eine gestrichelte Linienführung gekennzeichnet sind. Zwischen Bezugspotential und Bitleitung BL liegt eine Bitleitungsspannung U_{B} und der Sourceanschluß des Auswahltransistors AT ist mit einer Bitleitung BL verbunden, so daß ein Bitleitungsstrom i_{B} auf die Bitleitung BL fließen kann. Zwischen Bezugspotential und Wortleitung WL liegt eine Wortleitungsspannung u_{W} und der Gateanschluß des Auswahltransistors AT ist mit einer Wortleitung WL elektrisch leitend verbunden. Der Drainanschluß des Auswahltransistors AT besitzt mit dem sourceanschluß des Speichertransistors ST einen gemeinsamen Drain-Source-Knoten DSK, der über einen spannungsabhängigen Widerstand VR, der seinerseits aus einem Widerstand R und einer dazu parallelen Diode Di besteht, mit dem Gate des Speichertransistors verbunden ist. Das Gate des Speichertransistors ST weist eine Gatekapazität C_{G} gegenüber dem Bezugspotential auf und zwischen der Versorgungsspannungsleitung V und dem Bezugspotential liegt eine Spannung + V_{DD}.

Zusätzlich zur Gatekapazität C_{G} kann durch die in Figur 4 gezeigte Platte Pl eine zur Gatekapazität C_{G} parallelgeschaltete Zusatzkapazität C_{Z1} erzeugt werden. Da in Figur 4 das Substrat NSUB mit der Versorgungsspannung V_{DD} verbunden ist, ist besonders hier noch eine weitere Zusatzkapazität C_{Z2} zwischen der Versorgungsspannungsleitung V und dem Gate des Speichertransistors ST zu berücksichtigen. Der Übergang zwischen dem n-dotierten Drain-Source-Gebiet DS und dem angrenzenden p-dotierten Gebiet PSUB oder PG stellt eine in Sperrichtung gepolte parasitäre Diode Diₚₙ dar, durch die ein Leckstrom i_{L2} fließt. Für den Fall einer gespeicherten "logischen 1" kann erreicht werden, daß ein zum Auswahltransistor AT fließender Leckstrom i_{L1} zusammen mit dem Leckstrom i_{L2}, der durch die Diode Diₚₙ fließt, dem Betrag nach einem Subthresholdstrom i_{T} des Speichertransistors ST entspricht. Ist dies der Fall, so kann sich die am Gate des Speichertransistors ST wirksame Kapazität C nicht über den spannungsabhängigen Widerstand VR zum Drain-Source-Knoten DSK hin entladen und die Information der "logischen 1" bleibt länger erhalten. Im Falle einer eingespeicherten "logischen 0" befindet sich der Arbeitspunkt des Speichertransistors ST im Subthresholdbereich. Der Subthresholdstrom i_{T} verschiebt das Potential des gemeinsamen Drain-Source-Knotens DSK etwas nach oben, bis durch höhere Leckströme i_{L}₁ und i_{L2} ein Gleichgewicht entsteht.

Zum Einlesen einer "logischen 1" (high) werden, wie in Figur 7 gezeigt, eine Bitleitungsspannung u_{B} und eine Wortleitungsspannung u_{W} die innerhalb eines Zeitintervalls t₁ bis t₂ die Werte u_{BH}, u_{WH} (high) und sonst die Werte u_{BL}, u_{WL} (low) annehmen. Solange der Auswahltransistor AT durch eine Wortleitungsspannung U_{W} = u_{WH} (high) eingeschaltet ist, wird die anliegende Bitleitungsspannung u_{BH} (high) aber auch die Bitleitungsspannung u_{BL} (low) in die MOS-Transistorspeicherzelle eingelesen. Um eine, mit einer "logischen 1" (high) beschriebene, MOS-Transistorspeicherzelle durch eine Bitleitungsspannung u_{B} = u_{BL} (low) nach dem Zeitpunkt t2 nicht wieder teilweise zu entladen, sollte der Auswahltransistor vor dem Zeitpunkt t2 aufgrund einer Wortleitungsspannung U_{W} = U_{WL}(low) bereits sperren. Beim Einlesen einer "logischen 1" (high) liegt nach dem Durchschalten des Auswahltransistors AT die Bitleitungsspannung u_{B} = u_{BH} (high) am Drain-Source-Knoten DSK und lädt die am Gate des Speichertransistors ST wirksame Kapazität C über den in Flußrichtung gepolten, spannungsabhängigen Widerstand VR auf die Bitleitungsspannung u_{B} = u_{BH} (high) auf. Der spannungsabhängige Widerstand VR weist dabei einen niedrigen Widerstandswert in der Größenordnung von einigen 10 kOhm auf.

Beim Einlesen einer "logischen 0" (low) liegt nach dem Durchschalten des Auswahltransistors AT die Bitleitungsspannung u_{B} = u_{BL}(low) auch am Drain-Source-Knoten DSK, was zur Folge hat, daß eine auf die Spannung u_{BH} aufgeladene, am Gate des Speichertransistors ST wirksame Kapazität C über den in Sperrrichtung gepolten, spannungsabhängigen Widerstand VR auf u_{BL} mit der Zeitkonstante T = R*C entladen wird. Der in Sperrichtung gepolte, spannungsabhängige Widerstand VR weist dabei den hohen Widerstandswert R auf, der im Mega-Ohm-Bereich liegt. Die Kapazität C liegt hierbei im Bereich von einigen fF. Für ein vollständiges Entladen der am Gate des Speichertransistors wirksamen Kapazität C muß für eine Zeitdauer von mehreren Zeitkonstanten T der Auswahltransistor AT eingeschaltet sein.

Zum Auslesen wird die in Figur 8 gezeigte Wortleitungsspannung u_{W} angelegt, die in einem Zeitintervall t₃ bis t₄ den Wert u_{W} = u_{WH} (high) und sonst den Wert u_{W} = u_{WL} (low) annimmt. Im Zeitintervall t₃ bis t₄ ist der durch u_{W} angesteuerte Auswahltransistor AT durchgeschaltet und die Bitleitung BL dadurch mit dem Drain-Source-Knoten DSK verbunden. Ist die am Gate des Speichertransistors ST wirksame Kapazität C auf u_{BH} (high) aufgeladen und die Bitleitungsspannung u_{B} = u_{BL} (low), so fließt ein ebenfalls in Figur 8 dargestellter Bitleitungsstrom i_{B} auf die Bitleitung BL. Die abfallende Flanke des transienten Bitleitungsstroms i_{B} ist im wesentlichen durch die Zeitkonstante T = R*C bestimmt und das Zeitintegral von i_{B} stellt die beim Auslesen einer "logischen 1" (high) verfügbare Ladungsmenge Q dar. Ein transienter Stromfluß durch den Speichertransistor ST und damit auch ein transienter Bitleitungsstrom i_{B} wird dadurch erzeugt, daß das Gatepotential zeitlich verzögert dem Sourcepotential des Speichertransistors folgt und dadurch eine Gate-Source-Spannung entsteht die größer als die Schwellenspannung des Speichertransistors ST ist. Die Ladung Q besteht aus der Ladung der am Gate des Speichertransistors ST wirksamen Kapazität C und aus der um ein Vielfaches größeren, aus dem Drainstrom des Speichertransistors ST resultierenden Ladung. Ist die Ladungsmenge Q groß genug, so kann bei vorgegebener Bitleitungskapazität ein Spannungsimpuls auf der Bitleitung BL als "logische 1" detektiert werden.

Bei einer Skalierung der erfindungsgemäßen Anordnung mit MOS-Transistorspeicherzellen zu kleineren Zellgeometrien hin nehmen die Kanalweite und die Kanallänge ungefähr im selben Maß ab, dies bewirkt einen weitgehend unveränderten Drainstrom durch den Speichertransistor. Die Zeitkonstante T = R*C bleibt ebenfalls weitgehend unverändert, da der Widerstand R ungefähr im selben Maß zunimmt wie die Kapazität C abnimmt. Durch die weitgehende Konstanz des Drainstroms und der Zeitkonstante T ist auch die verfügbare Ladungsmenge Q weitgehend skalierungsunabhängig.

In den obigen Ausführungen entspricht die Bitleitungsspannung u_{B} = u_{BH} (high) einer "logischen 1", in entsprechender Weise könnte auch die Bitleitungsspannung u_{B} = u_{BL} (low) einer "logischen 1" zugeordnet werden.

Die erfindungsgemäße Anordnung kann nicht nur, wie gezeigt, in n-Kanal-Technologie aufgebaut werden, sondern auch in p-Kanal-Technologie. Hierzu sind bei allen Dotierungsgebieten die Leitungstypen von p nach n und umgekehrt zu vertauschen und die Vorzeichen der Spannungen zu ändern.

## Patentansprüche

1. Eine Anordnung mit selbstverstärkenden dynamischen MOS-Transistorspeicherzellen, mit einer Vielzahl von MOS-Transistorspeicherzellen, die nur mit jeweils einer Bitleitung (BL) elektrisch leitend verbunden sind,
die jeweils einen Auswahltransistor (AT) besitzen, dessen Gateanschluß mit einer Wortleitung (WL) elektrisch leitend verbunden ist,
und die jeweils einen Speichertransistor (ST) aufweisen, an dessen Gateanschluß eine Kapazität wirksam ist, um Informationen in Form von elektrischer Ladung zu speichern,
**dadurch gekennzeichnet,**
daß jeweils eine MOS-Transistorspeicherzelle mit lediglich einer einzigen Wortleitung (WL) elektrisch leitend verbunden ist,
daß sowohl der Auswahltransistor (AT) als auch der Speichertransistor (ST) jeweils aus einem MOS-Transistor bestehen,
daß ein zweiter Anschluß des Auswahltransistors (AT) jeweils mit der Bitleitung (BL) elektrisch leitend verbunden ist,
daß jeweils der dritte Anschluß des Auswahltransistors (AT) und ein zweiter Anschluß des Speichertransistors (ST) einen gemeinsamen Drain-Source-Knoten (DSK) bilden,
daß jeweils der dritte Anschluß des Speichertransistors (ST) mit einer Versorgungsspannung (V_{DD}) elektrisch leitend verbunden ist und
daß jeweils ein spannungsabhängiger Widerstand (VR) den gemeinsamen Drain-Source-Knoten (DSK) so mit dem Gateanschluß des Speichertransistors (ST) und einer an ihm wirksamen Kapazität (C) verbindet, daß ein niedriger Widerstandswert beim Aufladen und ein hoher Widerstandswert (R) beim Entladen der Kapazität (C) auftritt.

2. Anordnung mit selbstverstärkenden dynamischen MOS-Transistorspeicherzellen nach Anspruch 1, **dadurch** **gekennzeichnet,** daß jeweils der spannungsabhängige Widerstand (VR) dadurch gebildet wird, daß die Gate-Elektrode (GST) des Speichertransistors (ST) und das gemeinsame Drain- Source-Gebiet (DS) der beiden Transistoren (AT, ST) aus Halbleitermaterialien gleichen Leitungstyps bestehen, wobei die Gate-Elektrode (GST) des Speichertransistors (ST) jedoch eine höhere Dotierungskonzentration als das Drain-Source-Gebiet (DS) aufweist.

3. Anordnung mit selbstverstärkenden dynamischen MOS-Transistorspeicherzellen nach Anspruch 1, **dadurch** **gekennzeichnet,** daß jeweils die Gate-Elektrode (GST) des Speichertransistors (ST) und das gemeinsame Drain- Source-Gebiet (DS) der beiden Transistoren (AT, ST) aus Halbleitermaterialien gleichen Leitungstyps bestehen, wobei die Gate-Elektrode (GST) des Speichertransistors (ST) jedoch eine höhere Dotierungskonzentration als das gemeinsame Drain-Source-Gebiet (DS) aufweist und daß eine Metallschicht (M) zusammen mit der Gate-Elektrode (GST) des Speichertransistors (ST) eine Schottky-Diode bildet, die beim Aufladen der am Gate des Speichertransistors (ST) wirksamen Kapazität (C) einen niedrigeren Widerstand als beim Entladen dieser Kapazität (C) aufweist.

4. Anordnung mit selbstverstärkenden dynamischen MOS-Transistorspeicherzellen nach Anspruch 1, **dadurch** **gekennzeichnet,** daß jeweils die Gate-Elektrode (GST) des Speichertransistors (ST) und das gemeinsame Drain- Source-Gebiet (DS) der beiden Transistoren (AT, ST) aus hochdotierten Halbleitermaterialien gleichen Leitungstyps bestehen, zusätzlich aber ein hochdotiertes Gebiet (G) eines zur Gate-Elektrode (GST) und Drain-SourceGebiet (DS) unterschiedlichen Leitungstyps zwischen die Gate-Elektrode (GST) und das Drain-Source-Gebiet (DS) eingefügt ist, um einen spannungsabhängigen Widerstand (VR) zu bewirken, der beim Aufladen der am Gate des Speichertransistors (ST) wirksamen Kapazität (C) einen niedrigeren Widerstand als beim Entladen dieser Kapazität (C) aufweist.

5. Anordnung mit selbstverstärkenden dynamischen MOS-Transistorspeicherzellen nach Anspruch 1, **dadurch** **gekennzeichnet,** daß jeweils sowohl der Aus wahltransistor (AT) als auch der Speichertransistor (ST) planar aufgebaut sind.

6. Anordnung mit selbstverstärkenden dynamischen MOS-Transistorspeicherzellen nach Anspruch 1, **dadurch** **gekennzeichnet,** daß jeweils der Auswahltransistor (AT) planar aufgebaut ist und der Speichertransistor (ST) sich in einem Graben (T) befindet, wobei die Versorgungsspannung (V_{DD}) direkt über ein Substrat (NSUB) zuführbar ist.

7. Anordnung mit selbstverstärkenden dynamischen MOS-Transistorspeicherzellen nach Anspruch 1, **dadurch** **gekennzeichnet,** daß jeweils sowohl der Auswahltransistor (AT) als auch der Speichertransistor (ST) sich im selben Graben (T) befinden, wobei die Gate-Elektrode (GST) des Speichertransistors (ST) durch ein Zwischenoxid (ZOX) von einer Gate-Elektrode (GAT) des Auswahltransistors (AT) isoliert ist.

## Claims

1. Arrangement with self-amplifying dynamic MOS transistor storage cells, having a multiplicity of MOS transistor storage cells which are electrically conductively connected to only one bit line (BL) in each case, which in each case have one selection transistor (AT) whose gate terminal is electrically conductively connected to a word line (WL),
and which have in each case one storage transistor (ST) at whose gate terminal a capacitor acts in order to store information in the form of electrical charge,
characterised in that in each case one MOS transistor storage cell is electrically conductively connected to only a single word line (WL),
in that both the selection transistor (AT) and the storage transistor (ST) are composed in each case of an MOS transistor,
in that a second terminal of the selection transistor (AT) is electrically conductively connected in each case to the bit line (BL),
in that in each case the third terminal of the selection transistor (AT) and a second terminal of the storage transistor (ST) form a common drain-source node (DSK),
in that in each case the third terminal of the storage transistor (ST) is electrically conductively connected to a supply voltage (V_{DD}) and
in that in each case one voltage-dependent resistor (VR) connects the common drain-source node (DSK) to the gate terminal of the storage transistor (ST) and a capacitor (C), which acts at said terminal, in such a way that a low resistance value occurs during charging and a high resistance value (R) occurs during discharging of the capacitor (C).

2. Arrangement with self-amplifying dynamic MOS transistor storage cells according to Claim 1, characterised in that in each case the voltage-dependent resistor (VR) is formed by the gate electrode (GST) of the storage transistor (ST) and the common drain-source region (DS) of the two transistors (AT, ST) being composed of semiconductor materials of the same conductance type, the gate electrode (GST) of the storage transistor (ST) having however a higher doping concentration than the drain-source region (DS).

3. Arrangement with self-amplifying dynamic MOS transistor storage cells according to Claim 1, characterised in that in each case the gate electrode (GST) of the storage transistor (ST) and the common drain-source region (DS) of the two transistors (AT, ST) are composed of semiconductor materials of the same conductance type, the gate electrode (GST) of the storage transistor (ST) having however a higher doping concentration than the common drain-source region (DS), and in that a metallic layer (M) forms together with the gate electrode (GST) of the storage transistor (ST) a Schottky diode which has a lower resistance during the charging of the capacitor (C) which acts at the gate of the storage transistor (ST) than during the discharging of this capacitor (C).

4. Arrangement with self-amplifying dynamic MOS transistor storage cells according to Claim 1, characterised in that in each case the gate electrode (GST) of the storage transistor (ST) and the common drain-source region (DS) of the two transistors (AT, ST) are composed of highly doped semiconductor materials of the same conductance type, in addition however a highly doped region (G) of a conductance type which is different from the gate electrode (GST) and drain-source region (DS) is inserted between the gate electrode (GST) and the drain-source region (DS) in order to produce a voltage-dependent resistor (VR) which has a lower resistance during the charging of the capacitor (C) which acts at the gate of the storage transistor (ST) than during the discharging of this capacitor (C).

5. Arrangement with self-amplifying dynamic MOS transistor storage cells according to Claim 1, characterised in that in each case both the selection transistor (AT) and the storage transistor (ST) are of planar construction.

6. Arrangement with self-amplifying dynamic MOS transistor storage cells according to Claim 1, characterised in that in each case the selection transistor (AT) is of planar construction and the storage transistor (ST) is located in a trench (T), it being possible to feed in the supply voltage (V_{DD}) directly via a substrate (NSUB).

7. Arrangement with self-amplifying dynamic MOS transistor storage cells according to Claim 1, characterised in that in each case both the selection transistor (AT) and the storage transistor (ST) are located in the same trench (T), the gate electrode (GST) of the storage transistor (ST) being insulated from a gate electrode (GAT) of the selection transistor (AT) by an intermediate oxide (ZOX).

## Revendications

1. Dispositif comportant des cellules de mémoire dynamiques autoamplificatrices à transistors MOS, comportant une multiplicité de cellules de mémoire à transistors MOS, qui sont reliées d'une manière électriquement conductrice uniquement à respectivement une ligne (BL) de transmission de bits, et
qui comportent chacune un transistor de sélection (AT), dont la borne de grille est reliée de façon électriquement conductrice à une ligne (WL) de transmission de mots, et
qui comportent respectivement un transistor de mémoire (ST), sur la borne de grille duquel agit une capacité pour mémoriser des informations sous la forme d'une charge électrique,
caractérisé par le fait
que respectivement une cellule de mémoire à transistors MOS est reliée de façon électriquement conductrice uniquement à une seule ligne (WL) de transmission de mots,
qu'aussi bien le transistor de sélection (AT) que le transistor de mémoire (ST) sont constitués chacun d'un transistor MOS,
qu'une seconde borne du transistor de sélection (AT) est reliée d'une manière électriquement conductrice à la ligne (BL) de transmission de bits,
que la troisième borne du transistor de sélection (AT) et une seconde borne du transistor de mémoire (ST) forment un noeud drain-source commun (DSK),
que la troisième borne du transistor de mémoire (ST) est reliée de façon électriquement conductrice à une tension d'alimentation (V_{DD}), et
qu'une résistance (VR), qui dépend de la tension, relie le noeud commun drain-source (DSK) à la borne de grille du transistor de mémoire (ST) et à une capacité (C), qui agit sur ce transistor, de telle sorte qu'une petite valeur résistive apparaît lors de la charge de la capacité (C) et qu'une grande valeur résistive (R) apparaît lors de la décharge de la capacité (C).

2. Dispositif comportant des cellules de mémoire dynamiques autoamplificatrices à transistors MOS suivant la revendication 1, caractérisé par le fait que la résistance (VR) qui dépend de la tension, est formée par le fait que l'électrode de grille (GST) du transistor de mémoire (ST) et la région commune drain-source (DS) des deux transistors (AT, ST) sont en des matériaux semiconducteurs de même type de conductivité, l'électrode de grille (GST) du transistor de mémoire (ST) ayant cependant une concentration de dopage supérieure à celle de la région de drain-source (DS).

3. Dispositif comportant des cellules de mémoire dynamiques autoamplificatrices à transistors MOS suivant la revendication 1, caractérisé par le fait que l'électrode de grille (GST) du transistor de mémoire (ST) et la région commune de drain-source (DS) des deux transistors (AT, ST) sont en des matériaux semiconducteurs de même type de conductivité, l'électrode de grille (GST) du transistor de mémoire (ST) ayant cependant une concentration de dopage supérieure à celle de la région commune de drain-source (DS), et qu'une couche métallique (M) forme, conjointement avec l'électrode de grille (GST) du transistor de mémoire (ST), une diode Schottky, qui, lors de la charge de la capacité (C) qui agit sur la grille du transistor de mémoire (ST), présente une résistance plus faible que dans le cas de la décharge de cette capacité (C).

4. Dispositif comportant des cellules de mémoire dynamiques autoamplificatrices à transistors MOS suivant la revendication 1, caractérisé par le fait que l'électrode de grille (GST) du transistor de mémoire (ST) et la région commune de drain-source (DS) des deux transistors (AT, ST) sont en des matériaux semiconducteurs fortement dopés de même type de conductivité, mais qu'en outre une région fortement dopée (G) d'un type de conductivité différent de celui de l'électrode de grille (GST) et de la région de drain-source (DS), est insérée entre l'électrode de grille (GST) et la région de drain-source (DS), afin de produire une résistance (VR) qui dépend de la tension et qui, lors de la charge de la capacité (C) active sur la grille du transistor de mémoire (ST), présente une résistance plus faible que dans le cas de la décharge de cette capacité (C).

5. Dispositif comportant des cellules de mémoire dynamiques autoamplificatrices à transistors MOS suivant la revendication 1, caractérisé par le fait qu'aussi bien le transistor de sélection (21) que le transistor de mémoire (ST) sont planar.

6. Dispositif comportant des cellules de mémoire dynamiques autoamplificatrices à transistors MOS suivant la revendication 1, caractérisé par le fait que le transistor de sélection (AT) est planar et que le transistor de mémoire (ST) est situé dans un sillon (T), la tension d'alimentation (V_{DD}) pouvant être appliquée directement par l'intermédiaire d'un substrat (NSUB).

7. Dispositif comportant des cellules de mémoire dynamiques autoamplificatrices à transistors MOS suivant la revendication 1, caractérisé par le fait qu'aussi bien le transistor de sélection (AT) que le transistor de mémoire (ST) sont situés dans le même sillon (T), l'électrode de grille (GST) du transistor de mémoire (ST) étant isolée d'une électrode de grille (GAT) du transistor de sélection (AT) par un oxyde intercalaire (ZOX).
